# EUROPEAN PATENT APPLICATION

(11) **EP 1 199 804 A2**
(43) Date of publication of application: **24.04.2002**
(21) Application number: 01125042.0
(22) Date of filing: 15.10.2001
(51) Int. Cl.: H03L 7/085, H03D 13/00, H04L 7/033

(54) **Phase/frequency comparator**

(30) Priority: 19.10.2000 JP 2000319748
(71) Applicant: NEC CORPORATION, Tokyo (JP)
(72) Inventor: Noguchi, Hidemi, Tokyo (JP)
(74) Representative: Glawe, Delfs, Moll & Partner

(57) **Abstract**

The invention includes a first flip-flop (FF) 2 for taking in a clock signal CLK output of a voltage control oscillator 1 at a leading or trailing edge of a data signal to then output it, a delay circuit 3 for delaying the clock signal output of the voltage control oscillator by 90° a second FF4 for taking in the clock signal delayed at the delay circuit 3 at leading or trailing transition timing of the data signal to then output it, a logical product circuit 5 for AND'ing an output of the second FF and the clock signal CLK90 delayed by the delay circuit, a third FF6 for taking in an output of the first FF at leading or trailing transition timing of an output of the logical product circuit 5 to then output it, and an average detector circuit 7 for detecting a time-wise average of an output of the third FF6, an output voltage of which circuit 7 is fed back to a control terminal of the voltage control oscillator.

## Description

### BACKGROUND OF THE INVENTION

### 1. Field of the Invention

The invention relates to a phase/frequency comparator circuit and, more particularly to, a phase/frequency comparator circuit in a clock signal regenerating circuit.

### 2. Description of the Related Art

In the field of optical communication, to obtain appropriate timing for taking in data, a timing component (clock signal) is extracted from the received data signal and used. To do so, conventionally such a band pass filter as a SAW (Surface Acoustic Wave) filter has been used. With a recent tendency for incorporation of components into an Integrated Circuit (IC), such a clock signal regenerating method has been used in many cases that employs a voltage control oscillator (VCO) which can be realized using elements in an LSI (Large Scale Integration).

A conventional clock signal regenerating circuit used in a light reception apparatus is comprised of a PLL (Phase Locked Loop) circuit which includes a phase/frequency comparator circuit, a loop filter for smoothing a voltage of this phase/frequency comparator circuit, and VCO which receives an output of this loop filter as a control voltage. In such a light reception apparatus, a light signal is converted into an electric signal (current) by a photoelectric conversion circuit such as a photodiode. This current is then converted into a voltage and also amplified, so that thus amplified receive data signal is input to the phase/frequency comparator circuit. The data signal is compared at the phase/frequency comparator circuit to a clock signal sent from the VCO in terms of frequency and phase. Thus, a clock signal synchronized with the receive data signal is generated at the VCO.

Besides the above-mentioned configuration, such a configuration is known that in addition to a feed-back loop comprised of the phase comparator circuit, the loop filter, and the VCO, different frequency comparator circuit and loop filter are connected in parallel with this phase comparator circuit to thereby add outputs of these two loop filters and input thus obtained sum to the VCO as a control voltage, an output of which is in turn fed back to the phase comparator and frequency comparator circuits so that the frequency comparator side may detect frequency synchronization and then the phase comparator side may synchronize the phase.

The conventional clock signal regenerating circuit has a problem that the frequency comparator circuit has a large circuit.

The phase comparator circuit also needs to expand a range in which a phase can be compared correctly.

### SUMMARY OF THE INVENTION

In view of the above, it is an object of the invention to provide a phase/frequency comparator circuit that can be reduced in circuit scale.

It is another object of the invention to provide a phase/frequency comparator circuit that can expand a range in which a phase can be detected.

It is further object of the invention to provide a clock signal regenerating circuit, a reception apparatus, and a light reception apparatus that are provided with the above-mentioned phase/frequency comparator circuit to supply a control signal based on a frequency comparison result, thus causing a VCO to generate a clock signal synchronized with received data.

To this end, the invention is comprised of such a phase/frequency comparison circuit for comparing a frequency of a first signal to that of a second signal that includes a first sequential logical circuit for sampling the second signal at a leading or trailing edge of the first signal, a delay circuit for delaying the second signal by a predetermined phase, a second sequential logical circuit for sampling the second signal delayed by the delay circuit at a leading or trailing edge of the first signal, and a third sequential logical circuit for sampling an output of the first sequential logical circuit at a leading or trailing edge of a logical product of an output of the second sequential logical circuit and the second signal delayed y the delay circuit. The invention further includes an average detection circuit for detecting and outputting an average of the outputs of the third sequential logical circuit.

The invention may be of such a configuration that includes a first sequential logical circuit for sampling a second signal at a leading or trailing edge of a first signal, a delay circuit for delaying the second signal by a predetermined phase, a second sequential logical circuit for sampling the second signal delayed by the delay circuit at a leading or trailing transition edge of the first signal, and a third sequential logical circuit for providing an output, as it is, of the first sequential logical circuit when the second sequential logical circuit outputs a first value and holding the previous value of the second sequential logical circuit outputs a second value. The invention further includes an average detector circuit for detecting and outputting an average of the outputs of the third sequential logical circuit.

### BRIEF DESCRIPTION OF THE DRAWINGS

FIG. 1 is a circuit diagram for showing a configuration of a first embodiment of the invention;
FIG. 2 is a timing chart for showing operations of the first embodiment of the invention (fvco=fdata);
FIG. 3 is a timing chart for showing operations of the first embodiment of the invention (fvco=fdata);
FIG. 4 is a timing chart for showing operations of the first embodiment of the invention (fvco>fdata);
FIG. 5 is a timing chart for showing operations of the first embodiment of the invention (fvco>fdata);
FIG. 6 is a timing chart for showing operations of the first embodiment of the invention (fvco<fdata);
FIG. 7 is a timing chart for showing operations of the first embodiment of the invention (fvco<fdata);
FIG. 8 is a timing chart for showing operations of the first embodiment of the invention (with a synchronized frequency but with a shifted phase); and
FIG. 9 is a circuit diagram for showing a configuration of a second embodiment of the invention.

### DESCRIPTION OF THE PREFERRED EMBODIMENTS

The following will describe embodiments of the invention. One preferred embodiment of the invention has a signal oscillator (1) comprised of a voltage control oscillator (VCO) or a current control oscillator (ICO) which has a frequency control terminal, for oscillating a signal corresponding to a control voltage applied on this frequency control terminal. A phase/frequency comparator circuit of this embodiment includes a first flip-flop (2) for sampling an output clock signal of the signal oscillator (1) at a trailing or leasing edge of a receive data signal, a delay circuit (3) for delaying the output clock signal by a predetermined phase (90° ), a second flip-flop (4) for sampling the clock signal delayed by the delay circuit (3) at a trailing or leading edge of the data signal, a logical-product circuit (5) for an output of the second flip-flop and the clock signal (CLK90) delayed by 90° at the delay circuit (3), and a third flip-flop (6) for sampling an output of the first flip-flop at a trailing or leading edge of an output of the logical-product circuit (5). The phase/frequency comparator circuit of this embodiment further includes an average detector circuit (7) for detecting an average of outputs of the third flip-flop (6), so that an output of the average detector circuit (7) can be fed back to the signal oscillator (1) at its frequency control terminal to thereby control an oscillation frequency of the signal oscillator (1), thus causing the signal oscillator (1) to generate a clock signal synchronized with the data signal.

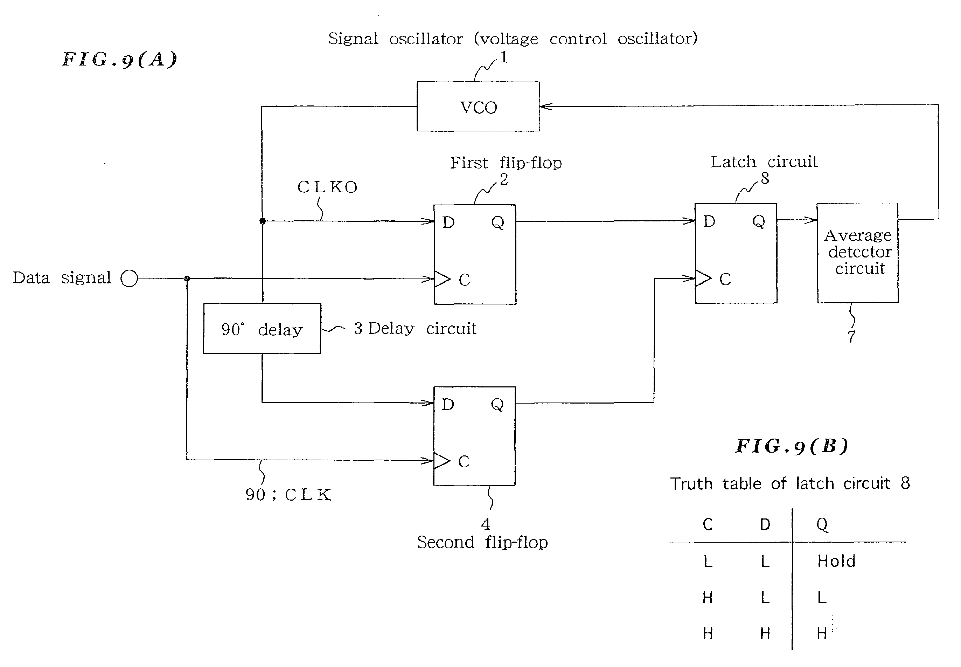

Another embodiment of the invention may be of such a configuration as shown in FIG. 9 including a latch circuit (8) (level-sensitive latch) in place of the edge-trigger type third flip-flop (6). That is, in this embodiment, the latch circuit (8) receives as an input both an output of the first flip-flop (2) and an output of the second flip-flop (4) so that it may provide the output, as it is, of the first flip-flop (1) when the second flip-flop (4) outputs a first value and holds the previous value when the second flip-flop (4) outputs a second value, while the average detector circuit (7) detects an average of the outputs of the latch circuit (8).

### Example

To further detail the above-mentioned embodiments of the invention, the following will describe embodiments thereof with reference to drawings.

### First Example

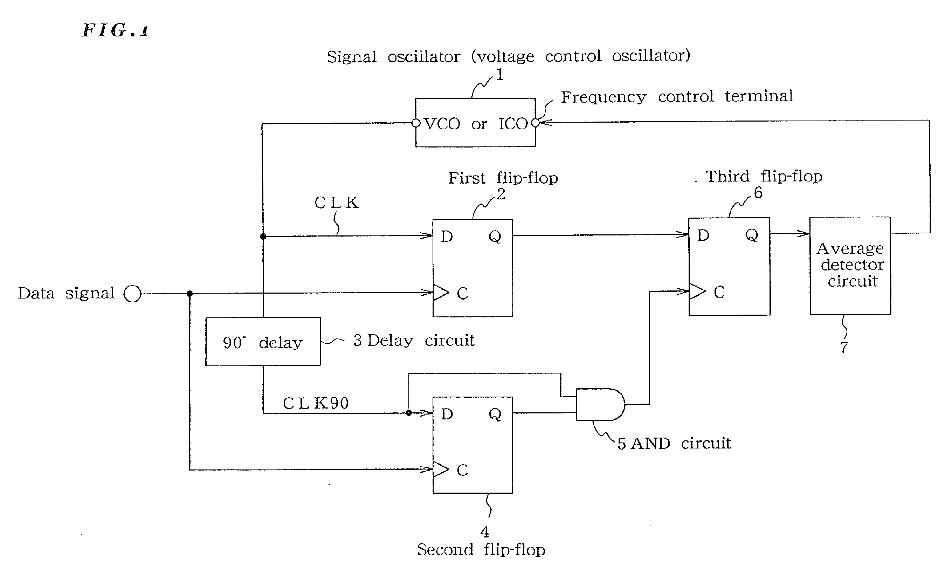

FIG. 1 is a circuit diagram for showing a configuration of a first embodiment of the invention.

As shown in FIG. 1, a phase/frequency comparator circuit of this first embodiment of the invention includes the VCO1 having a frequency control terminal, the first flip-flop 2 for receiving a clock signal CLK output from the VCO1 at its data terminal and a receive data signal at its clock signal terminal C, the delay circuit 3 for delaying a clock signal output from the VCO1 by 90° to then output it, the second flip-flop 4 having its data terminal D connected with an output of the delay circuit 3 and receiving the data signal at its clock signal terminal C, the AND circuit 5 for outputting a logical product of an output of the second flip-flop 4 and a clock signal output of the delay circuit 3, the third flip-flop 6 having its clock signal terminal C connected with an output terminal of the AND circuit 5 and its data terminal D connected with an output Q of the first flip-flop 2, and the average detector circuit 7 for detecting and then outputting a time-wise average of the output Q of the third flip-flop 6, in which an output (average) of the average detector circuit 7 is fed back to the frequency control terminal of the VCO (1) to thereby control the frequency thereof, thus generating a clock signal synchronized with the data signal. The first through third flip-flops 2, 4, and 6 each consist of a D-type flip-flop, which samples an input at the data terminal D at a leading or trailing edge of the signal at the clock signal terminal C. In this configuration, the VCO1 may be replaced by an ICO for converting a voltage of the control signal into a current based on which an oscillation frequency thereof may be changed.

Such a circuit as shown in FIG. 1 may be used in a reception apparatus etc. as a clock signal regenerating circuit for regenerating a clock signal from reception data, in which reception apparatus a light signal is converted at a photoelectric conversion circuit such as a photodiode into an electric signal (current) and then into a voltage, so that the receive data signal amplified to a necessary logical amplitude is input as the data signal in FIG. 1 to the clock signal terminal C of the first and second flip-flop 2 and 4.

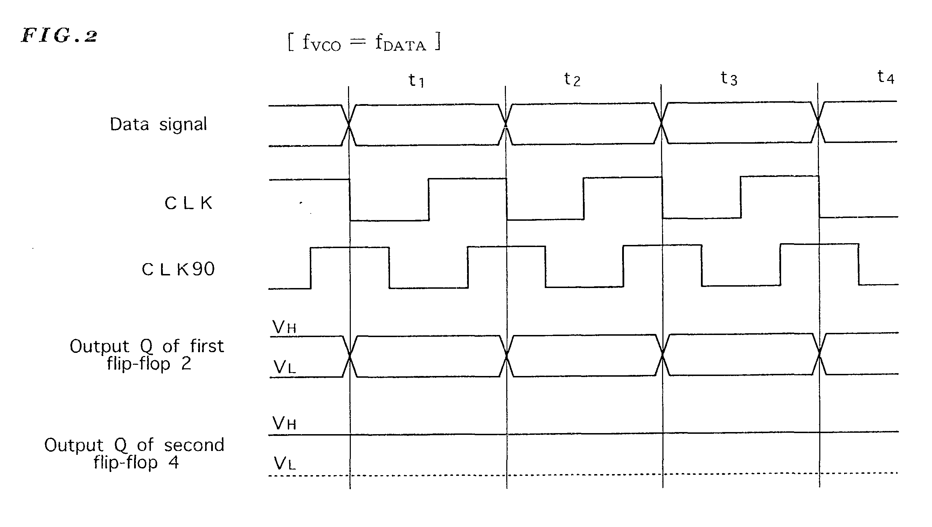

FIGS. 2-8 are timing charts for explaining the operations of the first embodiment.

The clock signal CLK output from the VCO1 is delayed by 90° at the VCO1 to provide a "CLK90".

Also, hereinafter, an oscillation frequency (frequency of the clock signal CLK) of the VCO1 is called fvco and a basic frequency of the receive data signal, fdata.

FIG. 2 is a timing chart for showing operations when the frequencies are synchronized with each other, that is, when fvco=fdata.

When the frequencies are synchronized with each other, the leading or trailing edge of the clock signal CLK agrees with a cross-point of the data signal always. This first embodiment is described with reference to a case where the trailing edge of the clock signal CLK agrees with the cross-point of the data signal.

The first flip-flop 2 samples a transition edge of the clock signal CLK entered at the data terminal C at a transition edge of the data signal entered at the clock signal terminal C. As a result, its output Q takes on a high-and-low level random pattern due to a relationship between a set-up time and a hold time.

The second flip-flop 4 samples the High-level V_{H} of the clock signal CLK90 and so its Q is at the High -level V_{H} always.

Since the output Q of the second flip-flop 4 is at the High-level, the AND circuit 5 for the output Q of the second flip-flop 4 and CLK90 as delayed by 90° at the delay circuit 3 outputs CLK90 as it is.

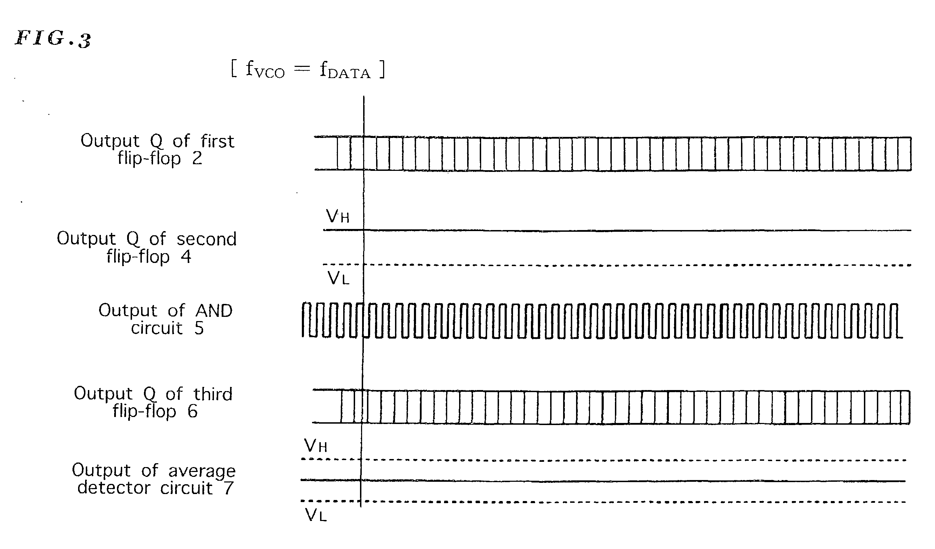

As shown in FIG. 3, at the clock signal terminal C of the third flip-flop 6 is entered CLK90 delayed by 90° at the delay circuit 3, so that the output Q of the third flip-flop 6 receiving the output Q (high-and-low level random pattern) of the first flip-flop 2 takes on a random pattern delayed by 90° with respect to the output of the first flip-flop 2.

Accordingly, an output Vav (average voltage) of the average detector circuit 7 for time-wise averaging the output Q of the third flip-flop 6 takes on (V_{H}+V_{L})/2, which is an intermediate value of the HIGH-level V_{H} and the Low-level V_{L}.

The average detector circuit 7 provides a time-wise average obtained by converting a High-level duration of the output Q of the flip-flop 2 in a predetermined time period into a DC voltage level. For example, it may be comprised of a low-pass filter including a CR circuit having its time constant set to a predetermined value or of a charge pump having such a configuration that the capacitor is charged at a constant current during a time when the output signal at the output terminal Q of the flip-flop 2 stays at the HIGH level and, for a period of the LOW level, is stopped in charging or discharged so that a voltage across the capacitor at a point in time when a predetermined time lapse has elapsed may be provided as a time-wise average.

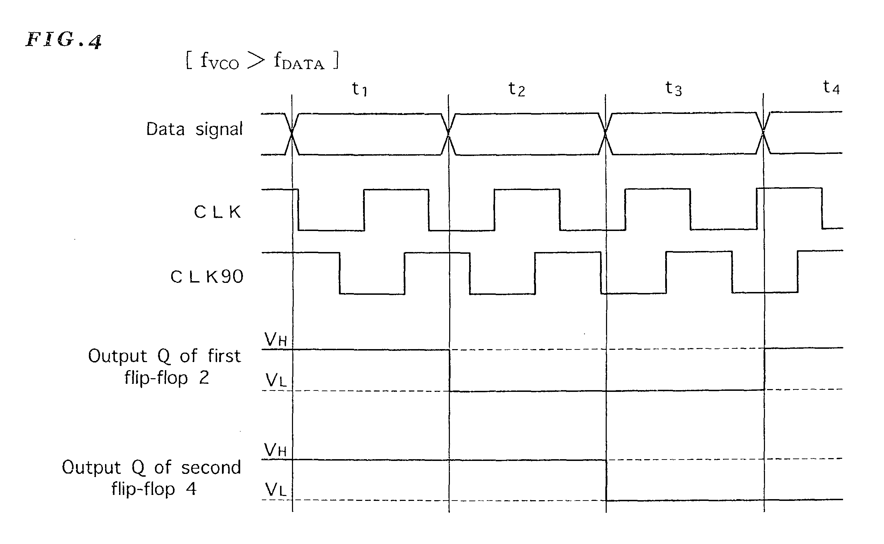

FIG. 4 is a timing chart for showing operations when the clock signal frequency fvco of the VCO1 is larger than the basic frequency fdata of the data signal (fvco>fdata).

When the clock signal frequency fvco of the VCO1 is larger than the basic frequency fdata of the data signal, as shown in FIG. 4, the cross-point of the data signal is shifted rightward with respect to output the clock signal CLK. That is, the data signal has a larger period than the clock signal CLK and so its cross-point is delayed for each cycle with respect to the transition of the trailing edge of the clock signal CLK.

Accordingly, by the first flip-flop 2, the timing the clock signal CLK is sampled at a variation point (transition edge) of the data signal is delayed (shifted rightward along the time axis in FIG. 4) for each cycle. When the HIGH-level V_{H} of the clock signal CLK is being sampled at the transition edge of the data signal, the output Q of the first flip-flop 2 stays at the HIGH-level V_{H}. When the Low-level V_{L} of the clock signal CLK is being sampled at the transition edge of the data signal, on the other hand, the output Q of the first flip-flop 2 stays at the Low-level V_{L}. Thus, the duration of the HIGH-level V_{H} and that of the Low-level V_{L} of the output Q of the first flip-flop 2 alternate with each other, so that a frequency at which they cycle once is equal to a difference between the frequency fdata of the data signal and the frequency fvco of the clock signal CLK.

The output Q of the first flip-flop 2 falls always earlier than the output of the second flip-flop 4 falls in timing. The output Q of the first flip-flop 2 which samples the clock signal CLK at the transition edge of the data signal takes on the LOW level in cycle t2, while the output Q of the second flip-flop 4 which samples CLK90 at the transition edge of the data signal takes on the LOW level in cycle t3.

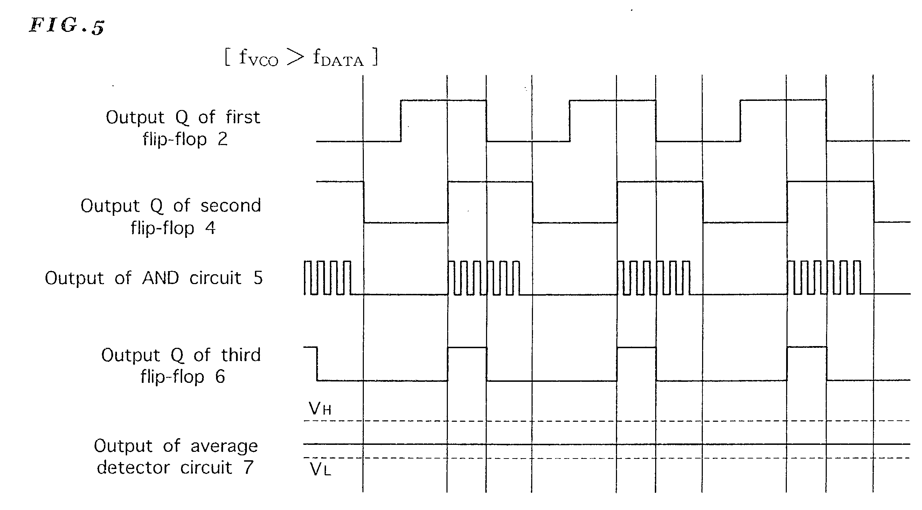

The following will describe operations of the first embodiment of the invention in a case where the clock signal frequency is higher than the data signal frequency (fvco>fdata) with reference to FIG. 5. The AND circuit 5 outputs CLK90 only when the output Q of the second flip-flop 4 is at the HIGH-level V_{H}. Accordingly, the output of the third flip-flop 6 takes on the High -level V_{H} only when the outputs Q of both the first flip-flop 2 and the second flip-flop 4 are at the High-level V_{H}.

When the AND circuit 5 does not output CLK90 (at the LOW level in FIG. 5) and the clock signal is not supplied to the clock signal terminal C of the third flip-flop 6, the third flip-flop 6 holds its previous state.

As can be seen from FIG. 5, the output q of the first flip-flop 2 always falls earlier than the output Q of the second flip-flop 4 falls in timing. In other words, the output Q of the second flip-flop 4 which samples CLK90 at the transition edge of the data signal rises as delayed by 90° with respect to the output Q of the first flip-flop 2 which samples the clock signal CLK by the data signal. Accordingly, the output Q of the third flip-flop 6 provides a clock signal which has a smaller duration of being at the HIGH-level V_{H}, so that the average detector circuit 7 outputs an intermediate value between (V_{H}+V_{L})/2 and V_{L} (see FIG. 5).

The VCO1 receives at the frequency control terminal an average output from the average detector circuit 7 and, based on the control signal, lowers its oscillation frequency. Accordingly, the frequency fvco of the clock signal output from the VCO1 and the frequency fdata of the receive data agree with each other.

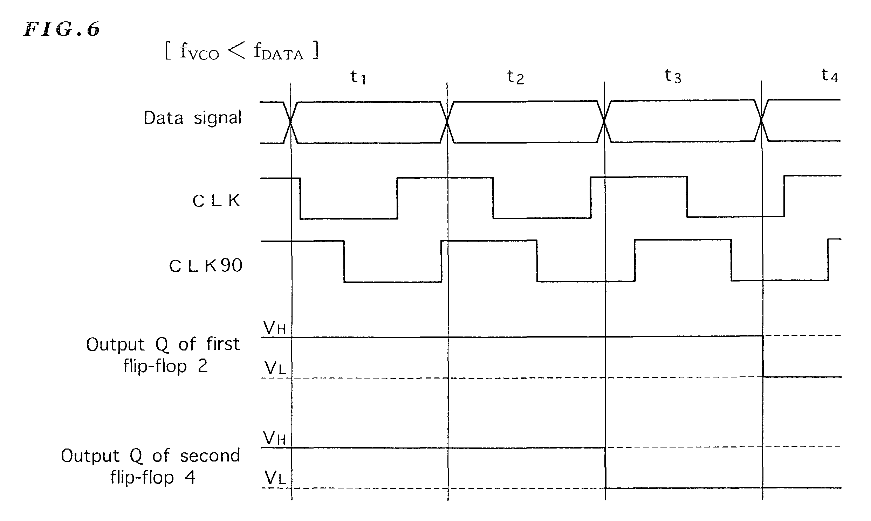

FIG. 6 is a timing chart for showing operations in a case where the clock signal frequency of the VCO1 is lower than the basic frequency fdata of the data signal (fvco<fdata).

When the frequency fvco of the clock signal CLK of the VCO1 is lower than the basic frequency fdata of the data signal, the cross-point of the data signal is shifted leftward along the time axis in FIG. 6 for each cycle with respect to the clock signal CLK. That is, the clock signal CLK has a longer period than the data signal, so that the cross-point of the data signal advances in timing for each cycle with respect to the trailing transition of the clock signal CLK.

Accordingly, by the first flip-flop 2, the timing the clock signal CLK is sampled at a transition edge of the data signal is shifted forward (leftward) along the time axis for each cycle. That is, when the High-level V_{H} of the clock signal CLK is being sampled at the transition edge of the data signal, the output Q of the first flip-flop 2 stays at the High-level VH, whereas when the LOW-level V_{L} of the clock signal CLK is being sampled at the transition edge of the data signal, the output Q of the first flip-flop 2 stays at the Low-level V_{L}. The output Q of the first flip-flop 2 becomes V_{H} and V_{L} levels alternately, so that a frequency at which these two levels cycle once is equal to a difference between the frequency fdata of the data signal and the frequency fvco of the clock signal CLK.

Also, the output Q of the first flip-flop 2 falls always later than the output of the second flip-flop 4 falls in timing.

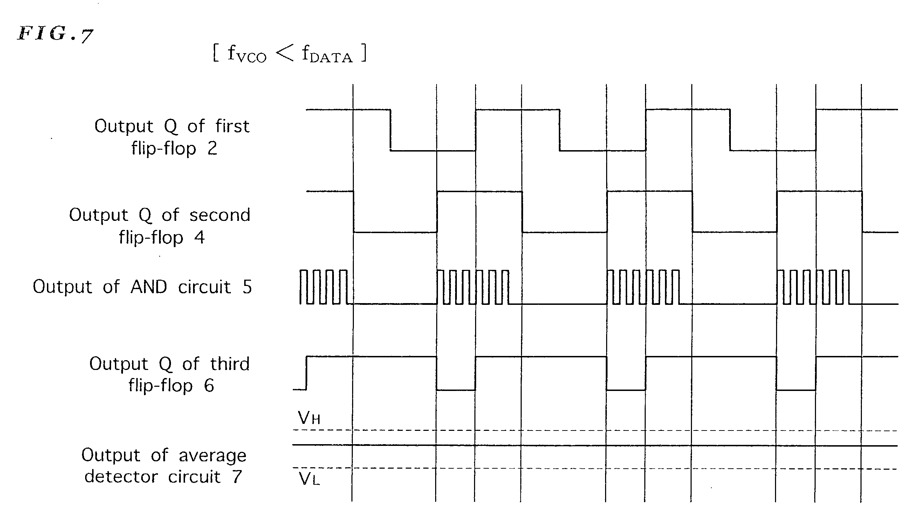

The following will describe operations of a case where the frequency of the clock signal fvco is lower than the basic frequency of the data signal fdata (fvco<fdata) with reference to FIG. 7. The AND circuit 5 outputs CLK90 only when the output Q of the second flip-flop 4 is at the HIGH-level V_{H}. Accordingly, the output of the third flip-flop 6 takes on the HIGH-level V_{H} only when the outputs Q of both the first flip-flop 2 and the second flip-flop 4 are at the HIGH-level V_{H}. When the AND circuit 5 does not output CLK90 (when the output of the second flip-flop 4 is at the Low-level V_{L}), the third flip-flop 6 holds its previous state.

As can be seen from FIG. 7, in this case, the output of the first flip-flop 2 rises later by 90° than the output of the second flip-flop 4, so that the output of the third flip-flop 6 provides a clock signal which has a larger duration of being at the HIGH-level V_{H}, which has an average between the intermediate value of (V_{H}+V_{L})/2 and the HIGH-level V_{H}. When this time-wise average is input to the VCO1, the frequency fvco of the VCO1 is increased.

By controlling the VCO1 so that the control voltage at the frequency control terminal may be held at the intermediate value of (V_{H}+V_{L})/2 always, it is possible to generate the clock signal CLK having the same frequency as the basic frequency of the data signal.

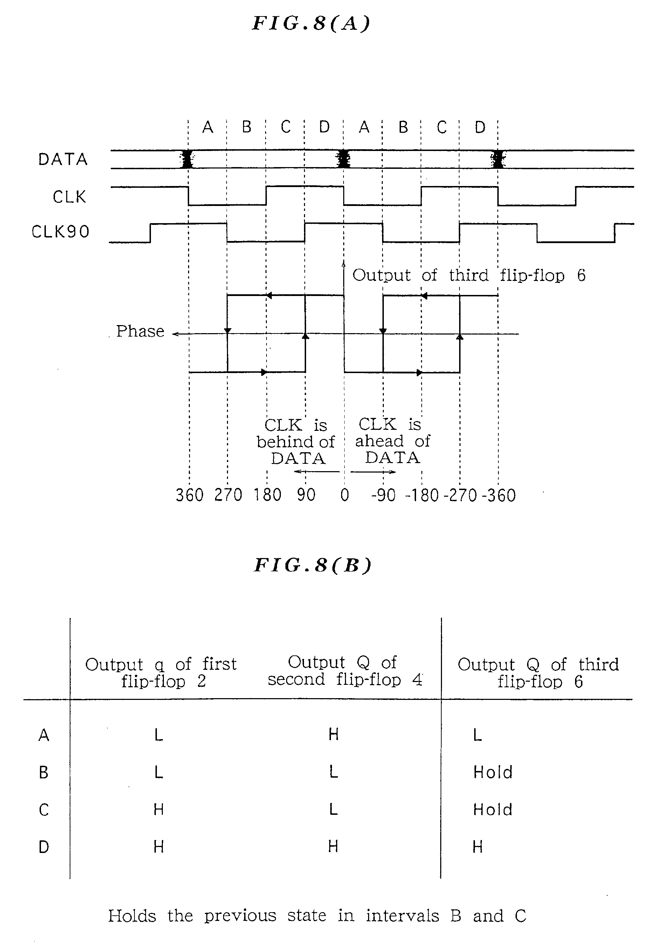

The following will describe, with reference to FIGS. 1 and 8, operations of a case where the frequency fdata of the data signal and the frequency fvco of the oscillation clock signal of the VCO1 agree with each other but they are different in phase, that is, the variation point of the data signal and the leading edge of the clock signal CLK do not agree.

Fig. 8(B) is a truth table indicating a relationship between the output of the first and second flip-flops 2 and 4 and the third flip-flop 6 and FIG. 8(A), a relationship among the timing waveforms of the data signal DATA, clock signal CLK, and clock signal CLK90 delayed at the delay circuit 3 by 90° , a phase difference between the data signal DATA and the clock signal CLK (a phase difference of 0 means phase agreement), and the output of the third flip-flop 6.

In the interval A (when the output Q of the first flip-flop 2 is at the LOW level and that of the second flip-flop 4 is at the HIGH level), the output of the third flip-flop 6 takes on the LOW-level V_{L}.

In the interval B (when the outputs Q of the first flip-flop 2 and the second flip-flop 4 are both at the LOW level), the third flip-flop6 holds the previous state of the High- or Low-level V_{H} or V_{L}. As can be seen from the relationship between the phase difference between the clock signal CLK and the data signal DATA and the output of the third flip-flop 6 shown in FIG. 8(A), no matter whether the clock signal CLK is ahead of or behind the data signal DATA in phase, over a transition from the interval A to the interval B, the third flip-flop 6 holds the Low-level output as has been in the interval A and, over a transition from the interval B to the interval C, holds the Low-level output as has been in the interval B.

In the interval D (when the outputs Q of the first and second flip-flops 2 and 4 are both at the High level), it provides the HIGH-level output. In this case also, since an average of the output Q of the third flip-flop 6 is different from the intermediate value (V_{H}+V_{L})/2, control is conducted so that a time-wise average of the output Q of the third flip-flop 6 may agree with (V_{H}+V_{L})/2, thus enabling obtaining a clock signal which is synchronized with the data signal both in frequency and in phase.

When a transition is made from the interval D to the interval C, the third flip-flop 6 holds the HIGH-level output as has been in the interval D, when a transition is made from the interval C to the interval B, it holds the HIGH-level output as has been the interval C, and when a transition is made from the interval B to the interval A, it provides the Low-level output.

Thus, in the embodiment of the invention, the relationship between a phase difference and the output of the third flip-flop 6 which indicates a result of comparison thereof has a hysteresis property such as shown in FIG. 8(A). That is, the transition of the output of the third flip-flop 6 with respect to a detected phase (phase difference between the clock signal CLK and the data signal DATA) has a directivity (such as indicated by an arrow) , in other words, there is a width (=180° ) between a phase (-270° , 90° (=-270° +360° )) at a transition of the output of the third flip-flop 6 from the LOW to HIGH levels and a phase (-90° , 270° (=-90° +360° )) at a transition from the HIGH to LOW levels, and, moreover, up to an expanded phase difference range of ±270° can be detected correctly, thus enhancing the tolerance against the noise and jitter in the data signal.

Such a comparison example as against this embodiment may be assumed in which a difference between the clock signal CLK and the data signal DATA is detected by only one flip-flop (e.g., the second flip-flop 2 in FIG. 1); in this case, a phase (±180°) at a transition of the output of this flip-flop from the LOW to HIGH levels agrees with a phase (±180°) at a transition from the HIGH to LOW levels to provide no hysteresis property, thus enabling correctly detecting only up to a phase difference less than ±180°.

### Second Example

The following will describe a second embodiment of the invention. FIG. 9 is a circuit diagram for showing a configuration of the second embodiment of the invention. As shown in it, in contrast to the above-mentioned embodiment, this embodiment uses the latch circuit 8 to replace the AND circuit 5 and the third flip-flop 6 (edge-trigger type D-flip-flop) as its feature. The latch circuit 8 consists of a level-sense type D-latch, acting to hold the previous state when the clock signal terminal C is at the Low-level and output as it is a state input at the data terminal when the clock signal terminal is at the High-level as shown in the truth table of FIG. 9(B).

The latch circuit 8 combines in operation the AND circuit 5 and the third flip-flop 6 shown in FIG. 1. Moreover, the latch circuit 8 can be realized in a half the circuit scale of the third flip-flop 6, thus effectively contributing the miniaturization and power-dissipation saving. Like the above-mentioned embodiment, this embodiment also provides a width between a phase at a transition from the output of the latch circuit 8 from the LOW to HIGH levels and a phase at a transition from the HIGH to LOW levels, thus enabling correctly detecting a phase difference of up to ±270.

As mentioned above, the configuration of the invention has two functions; a function to detect whether two signals are synchronized with each other in frequency to then feed back a detection result in the control signal to a signal oscillator comprised of a VCO or ICO so that the two signals may agree in frequency and another to detect a phase difference between two signals which agreed in frequency to then feed back a detection result in the control signal to the signal oscillator so that they may agree in phase.

Note here that the invention may not only be applied to a reception apparatus but also may be applied as it is as a phase/frequency comparator circuit in a PLL circuit for inputting a standard clock signal and outputting a signal synchronized with this reference clock signal. That is, by providing such a PLL circuit that, in the circuit described with the above-mentioned first embodiment which includes the first flip-flop 2, the delay circuit 3, the second flip-flop 4, the AND circuit 5, and the third flip-flop 6 or the circuit which includes the first flip-flop 2, the delay circuit 3, the second flip-flop 4, and the latch circuit 8, an output of the third flip-flop 6 or the latch circuit 8 respectively is smoothed into a DC voltage by the loop filter (or the average detector circuit 7), which is in turn supplied as a control signal to the VCO, a clock signal output from which is then directly given or frequency-divided by a frequency divider circuit to provide the clock signal CLK, which is input to the data terminal D of the first flip-flop 2 in the phase/frequency comparator circuit while at the same time the incoming reference signal (clock signal) is input at the clock signal terminal C of the first and second flip-flops 2 and 4, it is possible to obtain a clock signal synchronized with the reference signal from an output of the VCO or the frequency divider circuit.

As mentioned above, the invention gives an effect of simplifying a circuit configuration because a phase/frequency comparator circuit can be comprised of the first flip-flop which samples a clock signal output of the VCO at a trailing or leading edge of the data signal, the second flip-flop which samples the clock signal output as delayed by a predetermined phase at the trailing or leading edge of the data signal, the third flip-flop which samples an output of the first flip-flop at a transition edge of an AND signal obtained by AND'ing an output of the second flip-flop and the delayed clock signal output, and the average detector circuit which detects an output of the third flip-flop. By the invention, it is possible to feed back in configuration an output of the average detector circuit to the VCO at its frequency control terminal to thereby control an oscillation frequency of the VCO, thus generating a clock signal synchronized with the data signal.

Also, by the invention, even when the frequency of the data signal agrees with an oscillation frequency of the VCO but the transition point of the data signal does not agree with a leading or trailing edge of the clock signal in timing (that is, the phase is shifted), phase synchronization control can be conducted so that they may agree in phase.

Further, by the invention, it is possible to expand the range in which a phase difference between two signals can be detected correctly.

The invention may be embodied in other specific forms without departing from the spirit or essential characteristic thereof. The present embodiments are therefore to be considered in all respects as illustrative and not restrictive, the scope of the invention being indicated by the appended Claims rather than by the foregoing description and all changes which come within the meaning and range of equivalency of the Claims are therefore intended to be embraced therein.

The entire disclosure of Japanese Patent Application No. 2000-319748 (Filed on October 19, 2000) including specification, claims, drawings and summary are incorporated herein by reference in its entirety.

## Claims

1. A phase/frequency comparator circuit for comparing a first and second signals to each other in terms of frequency and phase, comprising:
a first sequential logical circuit for sampling and outputting said second signal at a leading or trailing edge of said first signal;
a delay circuit for delaying said second signal by a predetermined phase;
a second sequential logical circuit for sampling and outputting said second signal as delayed at said delay circuit, at a leading or trailing edge of said first signal; and
a third sequential logical circuit for sampling and outputting an output of said sequential logical circuit at a leading or trailing edge of a signal of a logical product of an output of said second sequential logical circuit and said second signal delayed at said delay circuit.

2. A phase/frequency comparator circuit for comparing a first and second signals to each other in terms of frequency and phase, comprising:
a first sequential logical circuit for sampling and outputting said second signal at a leading or trailing edge of said first signal;
a delay circuit for delaying said second signal by a predetermined phase;
a second sequential logical circuit for sampling and outputting said second signal as delayed at said delay circuit, at a leading or trailing edge of said first signal; and
a third sequential logical circuit for receiving as an input the outputs of said first and second sequential logical circuits to provide an output of said first sequential logical circuit when said second sequential logical circuit provides an output having a first value of signal level and holds the previous value when the second sequential logical circuit provides an output having a second value of signal level.

3. The phase/frequency comparator circuit according to Claim 1, wherein said first through third sequential logical circuits respectively comprise a first through third flip-flops for sampling a signal input at a data input terminal, at a leading or trailing edge of a signal input at a clock signal input terminal.

4. The phase/frequency comparator circuit according to Claim 2, wherein:
said first and second sequential logical circuits respectively comprise a first and second flip-flops for sampling a signal input at a data input terminal, at a leading or trailing edge of a signal input at a clock signal input terminal; and
said third sequential logical circuit is comprised of a latch circuit for providing, as is ,a signal input at said data input terminal from an output terminal thereof when a signal input at said clock signal input terminal has a first value of signal level and holding the previous value at said output terminal when said signal input at said clock signal input terminal has a second value of signal level.

5. The phase/frequency comparator circuit according to any one of Claims 1 through 4, wherein said delay circuit delays a phase of said second signal by a half of a pulse width of said second signal.

6. The phase/frequency comparator circuit according to any one of Claims 1 through 4, wherein said delay circuit delays a phase of said second signal by 90°.

7. The phase/frequency comparator circuit according to any one of Claims 1 through 6, further comprising an average detector circuit for detecting and outputting an average of the output of said third sequential logical circuit.

8. the phase/frequency comparator circuit according to Claim 7, wherein said average detector circuit outputs as said average a DC voltage indicating a time lapse over which a signal input to said average detector circuit holds a first or second value in a predetermined time period.

9. A clock signal regenerating circuit, comprising:
a phase/frequency comparator circuit as claimed in Claim 7 or 8; and
a signal oscillator comprised of a voltage control oscillator or a current control oscillator for changing an oscillation frequency based on a frequency control signal input at a frequency control terminal to then output a clock signal having said oscillation frequency, wherein:
a clock signal output from said signal oscillator is fed as said second signal to said phase/frequency comparator circuit, a reception data signal is fed as said first signal to said phase/frequency comparator circuit, and an output of said average detector circuit is fed as said frequency control signal to said frequency control terminal of said signal oscillator; and
said signal oscillator then outputs a clock signal synchronized with said reception data signal.

10. A light reception apparatus comprising:
a phase/frequency comparator circuit as claimed in Claim 7 or 8; and
a signal oscillator comprised of a voltage control oscillator or a current control oscillator for changing an oscillation frequency based on a frequency control signal input at a frequency control terminal to then output a clock signal having said oscillation frequency, wherein:
a clock signal output from said signal oscillator is fed as said second signal to said phase/frequency comparator circuit;
a reception data signal converted into an electric signal through photoelectric conversion means for receiving a light signal is fed as said first signal to said phase/frequency comparator circuit, while an output of said average detector circuit is fed as said frequency control signal to said frequency control terminal of said signal oscillator; and
said signal oscillator then outputs a clock signal synchronized with said reception data signal.

11. A PLL circuit comprising:
a phase/frequency comparator circuit as claimed in any one of Claims 1 through 6; and
a signal oscillator comprised of a voltage control oscillator or a current control oscillator for changing an oscillation frequency based on a frequency control signal input at a frequency control terminal to then output a clock signal having said oscillation frequency, wherein:
an oscillation clock signal output from said signal oscillator is fed directly to or frequency-divided at a frequency divider circuit and then fed said phase/frequency comparator circuit as said second signal;
an incoming reference signal is fed to said phase/frequency comparator circuit as said first signal; and
an output of said third sequential logical circuit in said phase/frequency comparator circuit is fed through a loop filter to said frequency control terminal of said signal oscillator as said frequency control signal, so that said signal oscillator or said frequency divider circuit outputs a clock signal synchronized with said reference signal.

12. A clock signal regenerating circuit comprising:
a voltage control oscillator having a frequency control terminal, for oscillating a frequency which corresponding to a control voltage applied at said frequency control terminal;
a first flip-flop for receiving as an input a clock signal output of said voltage control oscillator at a data input terminal and also receiving an incoming data signal at a clock signal input terminal, for sampling a clock signal output from said voltage control oscillator to then output said clock signal from an output terminal;
a delay circuit for delaying said clock signal output from said voltage control oscillator by a predetermined phase to then output said clock signal;
a second flip-flop receiving as an input said clock signal delayed by said delay circuit and also receiving said data signal at a clock signal input terminal, for sampling said clock signal delayed by said delay circuit at leading or trailing edge of said data signal to then output said clock signal from said output terminal;
a logical product circuit for AND'ing an output of said second flip-flop and said clock signal delayed by said delay circuit to then output a resultant logical product;
a third flip-flop receiving as an input an output of said first flip-flop at said data input terminal and also receiving an output of said logical product circuit at said clock signal input terminal, for sampling an output of said first flip-flop at a leading or trailing edge of an output of said logical product circuit to then provide said output from said output terminal; and
an average detector circuit for detecting an average of an output of said third flip-flop,
wherein an average output from said average detector circuit is fed back to said frequency terminal of said voltage control oscillator to thereby control an oscillation frequency of said voltage control oscillator, thus generating a clock signal synchronized with said data signal.

13. A clock signal regenerating circuit comprising:
a voltage control oscillator having a frequency control terminal, for oscillating a frequency which corresponding to a control voltage applied at said frequency control terminal;
a first flip-flop for receiving as an input a clock signal output of said voltage control oscillator at a data input terminal and also receiving an incoming data signal at a clock signal input terminal, for sampling a clock signal output from said voltage control oscillator to then output said clock signal from an output terminal;
a delay circuit for delaying said clock signal output from said voltage control oscillator by a predetermined phase to then output said clock signal;
a second flip-flop receiving as an input said clock signal delayed by said delay circuit and also receiving said data signal at a clock signal input terminal, for sampling said clock signal delayed by said delay circuit at leading or trailing edge of said data signal to then output said clock signal from said output terminal;
a latch circuit receiving as an input an output of said first flip-flop and an output of said second flip-flop, for providing an output of said flip-flop as it is from an output terminal when said second flip-flop gives a first value of output level and holding the previous value when said second flip-flop gives a second value of output level; and
an average detector circuit for detecting an average of an output of said third flip-flop,
wherein an average output from said average detector circuit is fed back to said frequency terminal of said voltage control oscillator to thereby control an oscillation frequency of said voltage control oscillator, thus generating a clock signal synchronized with said data signal.

14. The clock signal regenerating circuit according to Claim 12 or 13, wherein said delay circuit delays a phase of said clock signal by a phase which corresponds to a half of a pulse width of said clock signal pulse.

15. The clock signal regenerating circuit according to Claim 12 or 13, wherein said delay circuit delays a phase of said clock signal by 90°.

16. The clock signal regenerating circuit according to Claim 12 or 13, wherein said average detector circuit outputs as said average a DC current which indicates a time lapse over which a signal input to said average detector circuit holds a first or second value in a predetermined time period.
